# EUROPEAN PATENT APPLICATION

(11) **EP 0 996 155 A2**
(43) Date of publication of application: **26.04.2000**
(21) Application number: 99121064.2
(22) Date of filing: 21.10.1999
(51) Int. Cl.: H01L 23/36

(54) **Radio frequency integrated circuit apparatus**

(30) Priority: 23.10.1998 JP 30227598
(71) Applicant: SONY CORPORATION, Tokyo (JP)
(72) Inventor: Suhara, Akira, c/o Sony Corporation, Tokyo (JP); Ooke, Hajime, c/o Sony Corporation, Tokyo (JP)
(74) Representative: MÜLLER & HOFFMANN Patentanwälte

(57) **Abstract**

A radio frequency integrated circuit apparatus is disclosed, that comprises a first circuit device (2), generating a large amount of heat, disposed on one surface of a circuit substrate (1), a second circuit device (3), generating a small amount of heat, disposed on the other surface of the circuit substrate, and a heat radiating means (4) for radiating the heat generated by the first circuit device.

## Description

### BACKGROUND OF THE INVENTION

### Field of the Invention

The present invention relates to a radio frequency integrated circuit apparatus suitable for a radio frequency power amplifier for use with a portable telephone terminal, in particular, to a radio frequency integrated circuit apparatus whose size is small and that has a high heat radiation effect.

### Description of the Related Art

In recent years, mobile communication systems such as mobile telephone systems are drastically advancing. For example, in Japan, 800 MHz-band and 1.5 GHz-band digital cellular (PDC) systems, 1.9 GHz-band personal handy phone system (PHS) have been commercially used. Outside Japan, a plurality of systems such as GSM (Group Special Mobile) system have been used.

As factors of the growth of such systems, as well as enriched services, it is necessary to reduce the size and weight of portable terminals. Of course, it has been desired to reduce the size and weight of integrated circuits. From such a viewpoint, CSP (Chip Size/Scale Package) method that allows a chip to be mounted on a substrate whose size is the same as a small mold package or the chip is becoming attractive.

Particularly, with respect to an integrated circuit for a radio frequency amplifier of a portable terminal, it is desired to mount a matching circuit (that matches the impedance of the amplifier and the impedance of the antenna) and a bias circuit (that sets the operation point of the amplifier) in the same package so as to assure the performance of the integrated circuit and to reduce the number of adjusting portions. Thus, it is desired to further reduce the size of such an integrated circuit. In addition, with respect to an integrated circuit for a radio frequency amplifier, since it consumes a large power, it is necessary to radiate heat generated in the circuit to the outside.

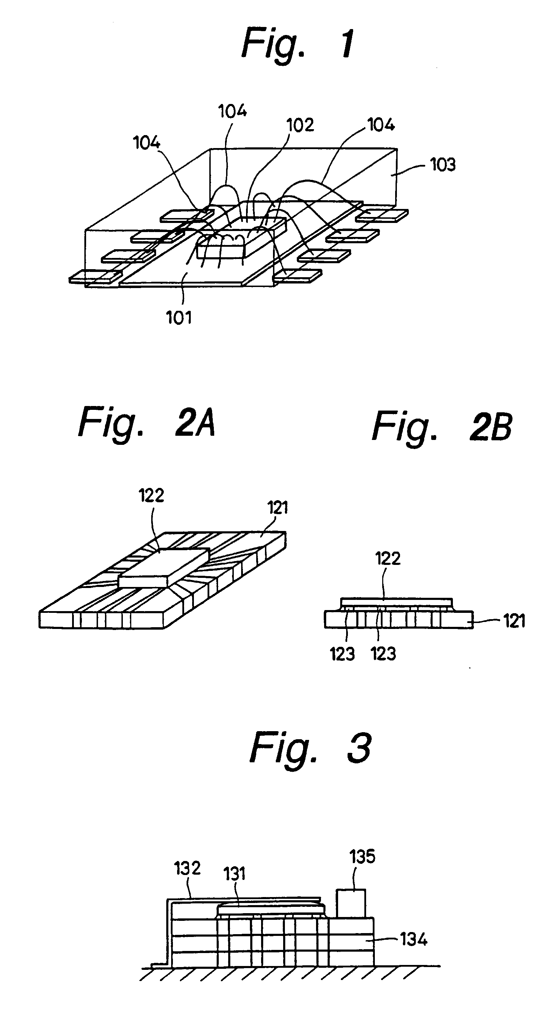

Conventionally, as shown in Fig. 1, a die pad portion 101 on the rear surface of a package 103 of a semiconductor chip 102 is exposed so as to improve heat radiation effect. Although this structure has a high heat radiation efficiency, since its size cannot be sufficiently reduced, it is difficult to mount a bias circuit and a matching circuit on the package. However, since this structure uses wire bonding method, wires 104 cause inductance components to increase. Thus, because of the deviation of the lengths of the wires, the inductance components fluctuate. Consequently, a characteristic fluctuation takes place.

To prevent the characteristic fluctuation and the characteristic deterioration due to the fluctuation of inductance, an integrated circuit whose size is reduced according to flip-chip method is known (see Figs. 2A and 2B). In the flip-chip method shown in Fig. 2B, when a semiconductor chip 122 is mounted on a substrate 121, bumps 123 are formed on the semiconductor chip 122. The semiconductor chip 122 is mounted on the substrate 121 according to re-flow method.

However, when the semiconductor chip 122 is mounted according to flip-chip method, in consideration of the heat radiation efficiency, the semiconductor chip 122 should be mounted on the substrate 121 that is a single-layered substrate that has high thermal conductivity and whose thickness is as small as possible. Thus, it is difficult to use a multi-layered substrate. Consequently, since a bias circuit, a matching circuit, and so forth should be two-dimensionally disposed, flip-chip method is not advantageous to reduce the size of the integrated circuit.

As shown in Fig. 3, when a heat radiation case 132 that encloses a semiconductor chip 131 is mounted, a multi-layered substrate 134 may be used. However, when such a heat radiation case 132 is used, a chip part 135 that accomplishes a matching circuit and a bias circuit should be mounted in a narrow region on the top layer of the substrate 134 along with the semiconductor chip 131. Thus, it is difficult to mount a plurality of parts. Normally, the thickness of the semiconductor chip 131 is smaller than the thickness of the chip part 135 that accomplishes the matching circuit and the bias circuit. Thus, when the semiconductor chip 131 is enclosed with the heat radiation case 132, the mounting region of the chip part 135 is restricted. Thus, the degree of freedom of the placement of the chip part 135 becomes low.

It is required to dispose a matching circuit and a bias circuit in a radio frequency integrated circuit apparatus. To effectively dispose these matching circuit and bias circuit, it is preferred to mount them on a multi-layered substrate according to flip-chip method. However, when a semiconductor chip is mounted according to flip-chip method, a single-layered substrate with high thermal conductivity should be used. Thus, it was difficult to use a multi-layered substrate. In addition, when a heat radiation case is used, the mounting region is restricted. Thus, the degree of freedom of the placement of parts becomes low.

### OBJECT AND SUMMARY OF THE INVENTION

Therefore, an object of the present invention is to provide a radio frequency integrated circuit apparatus that solves the problem of heat radiation and that allows parts to be effectively mounted on a substrate.

The present invention is a radio frequency integrated circuit apparatus, comprising a first circuit device, generating a large amount of heat, disposed on one surface of a circuit substrate, a second circuit device, generating a small amount of heat, disposed on the other surface of the circuit substrate, and a heat radiating means for radiating the heat generated by the first circuit device.

The first circuit device is mounted according to flip-chip method.

The circuit substrate is a multi-layered substrate.

The multi-layered substrate has a ground layer.

The first circuit device is a semiconductor chip for amplifying the power of a radio frequency signal. The second circuit device is a chip part that composes a matching circuit and a bias circuit.

The heat radiating means functions as a cover for enclosing the circuit substrate on which the first circuit device and the second circuit device have been mounted, the first circuit device being contacted with the cover so as to radiate the heat generated by the first circuit device.

According to the present invention, since a radio frequency integrated circuit apparatus according to the present invention comprises a first circuit device, generating a large amount of heat, disposed on one surface of a circuit substrate, a second circuit device, generating a small amount of heat, disposed on the other surface of the circuit substrate, and a heat radiating means for radiating the heat generated by the first circuit device, the mounting area becomes large. In addition, the problem of the heat generation can be solved.

According to the present invention, since the first circuit device, generating a large amount of heat, is mounted according to flip-chip method, the fluctuation of the wire lengths and inductance components can be suppressed.

According to the present invention, since the circuit substrate is a multi-layered substrate, parts can be densely mounted. In addition, since the multi-layered substrate contains a ground layer, it prevents electric signals from interfering and causes the thermal resistance of the apparatus to lower.

According to the present invention, since the heat radiating means functions as a cover for enclosing the circuit substrate on which the first circuit device, generating a large amount of heat, and the second circuit device, generating a small amount of heat, have been mounted, a special member for radiating heat can be omitted.

These and other objects, features and advantages of the present invention will become more apparent in light of the following detailed description of a best mode embodiment thereof, as illustrated in the accompanying drawings.

### BRIEF DESCRIPTION OF THE DRAWINGS

Fig. 1 is a perspective view for explaining the structure of a conventional radio frequency integrated circuit apparatus;
Fig. 2A is a perspective view for explaining the structure of another conventional radio frequency integrated circuit apparatus;
Fig. 2B is a sectional view of the structure of Fig. 2A;
Fig. 3 is a sectional view for explaining the structure of another conventional radio frequency integrated circuit apparatus;
Fig. 4 is a sectional view showing the structure of an integrated circuit apparatus according to a first embodiment of the present invention;
Fig. 5 is a perspective view for explaining the structure of an electrode according to the first embodiment of the present invention;
Fig. 6 is a perspective view for explaining the structure of electrodes according to the first embodiment of the present invention;
Figs. 7A to 7D are perspective views for explaining the structure of a multi-layered substrate according to the first embodiment of the present invention;
Fig. 8 is a sectional view for explaining the structure of the integrated circuit apparatus according to the first embodiment of the present invention;
Fig. 9 is a sectional view for explaining the structure of an integrated circuit apparatus according to a modification of the first embodiment of the present invention;
Fig. 10 is a sectional view for explaining the structure of an integrated circuit apparatus according to another modification of the first embodiment of the present invention;
Fig. 11 is a sectional view for explaining the structure of an integrated circuit apparatus according to a second embodiment of the present invention;
Fig. 12 is a perspective view of the structure of Fig. 11;
Fig. 13 is a sectional view for explaining the structure of an integrated circuit apparatus according to a third embodiment of the present invention;
Fig. 14 is a perspective view of the structure of Fig. 13; and
Fig. 15 is a sectional view showing the structure of an integrated circuit apparatus according to a modification of the third embodiment of the present invention.

### DETAILED DESCRIPTION OF THE PREFERRED EMBODIMENTS

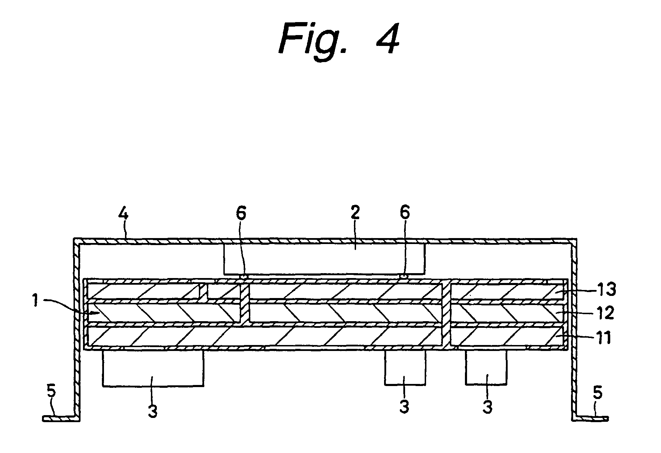

Next, with reference to the accompanying drawings, embodiments of the present invention will be described. Fig. 4 is a sectional view showing the structure of an integrated circuit apparatus according to a first embodiment of the present invention. The integrated circuit shown in Fig. 4 is used for a radio frequency amplifier of a portable communication terminal. The radio frequency amplifier amplifies the power of a transmission signal. The integrated circuit apparatus contains an active device and a passive device. The active device amplifies the power of a transmission signal. The passive device composes a bais circuit and a matching circuit.

In Fig. 4, reference numeral 1 is a substrate that mounts a semiconductor chip. Examples of the material of the substrate 1 are aluminum nitride, alumina, silicon nitride, glass ceramic, and glass epoxy. The material of the substrate 1 is selected from these dielectric substances in consideration of the dielectric constant and cost.

The substrate 1 is a multi-layered substrate having for example three substrate layers 11 to 13. With the multi-layered substrate 1, circuit devices are disposed in the middle substrate layers. Thus, a matching circuit and a bias circuit can be disposed in a small structure. Instead of the multi-layered substrate, a single-layered substrate may be used.

The semiconductor chip 2 is mounted on the upper surface of the substrate 1 through bumps 6 according to flip-chip method. Chip parts 3, 3, ... such as resistor devices and capacitor devices are mounted on the lower surface of the substrate 1. The semiconductor chip 2 amplifies the power of a radio frequency signal. The chip parts 3, 3, ... compose a matching circuit and a bias circuit. The amount of heat generated by the chip parts 3, 3, ... disposed on the lower surface of the substrate 1 is small. However, since the amount of heat generated by the semiconductor chip 2 mounted on the upper surface of the substrate 1 is large because the semiconductor chip 2 amplifies the power of a radio frequency signal, the heat should be radiated.

Thus, in the example, the semiconductor chip 2 that generates a large amount of heat is mounted on the upper surface of the substrate 1. The chip parts 3, 3, ... that generates a small amount of heat are mounted on the rear surface of the substrate 1. In other words, parts are mounted on both the surfaces of the substrate 1. Since the parts are mounted on both the surfaces of the substrate, the substrate area can be effectively used. Thus, the size of the apparatus can be reduced.

A cover 4 that fully encloses the substrate 1 is disposed on the substrate 1 on which the semiconductor chip 2 and the chip parts 3, 3, ... have been mounted. An example of the material of the cover 4 is metal having high thermal conductivity. A connection portion 5 is disposed on the outer periphery at the bottom of the cover 4. The connection portion 5 connects the integrated circuit apparatus to a mother board. The rear surface of the upper portion of the cover 4 contacts the upper surface of the semiconductor chip 2.

Since the semiconductor chip 2 amplifies the power of a radio frequency signal, it generates a large amount of heat. The heat generated by the semiconductor chip 2 flows to the cover 4 that contacts the semiconductor chip 2. Since the outer periphery of the cover 4 is wisely exposed to air, the heat that flows to the cover 4 is radiated to air. In addition, when the cover 4 is connected to the mother board through the connection portion 5, the heat of the cover 4 is radiated from the mother board.

In addition to the heat radiation of the semiconductor chip 2, the cover 4 prevents dust from entering the integrated circuit apparatus and shields it against an external electromagnetic radiation source.

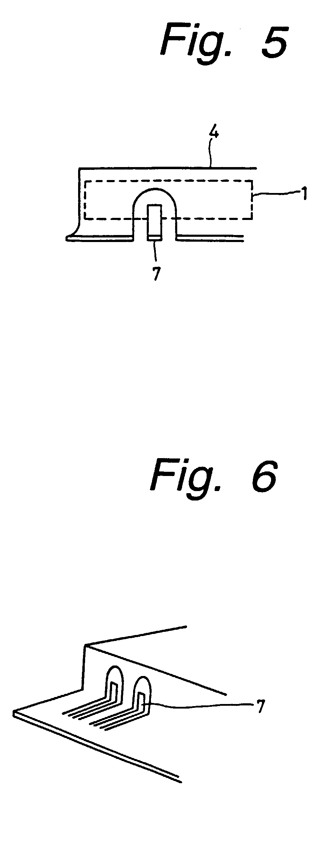

Fig. 4 is a sectional view showing a part of the integrated circuit apparatus. However, as shown in Fig. 5, electrodes 7 are connected to a side portion of the multi-layered substrate 1. As shown in Fig. 6, when the cover is contacted with the rear surface of the chip, the side portion of the multi-layered substrate is connected. Finally, the periphery of the cover is cut along a predetermined cut line. Thus, the electrodes 7 are formed. In this case, since covers formed on a lead-frame are used, the electrodes 7 can be formed with high productivity.

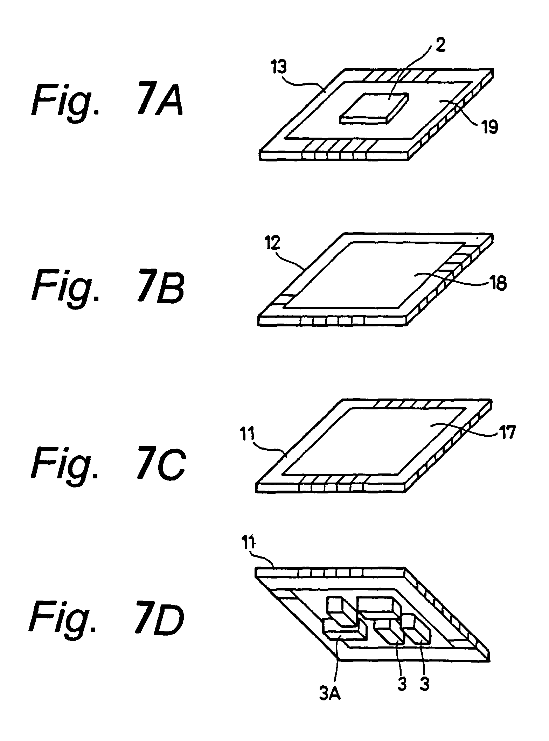

As described above, according to the first embodiment of the present invention, the three-layered substrate having the substrate layers 11 to 13 is used. Fig. 7 shows the structure of such a multi-layered substrate.

In Figs. 7A to 7D, the substrate layer 11 is the bottom substrate layer. A strip line (not shown) is formed on the lower surface of the substrate layer 11 shown in Fig. 7D. In addition, the chip parts 3, 3, ... are mounted on the lower surface of the substrate layer 11. As shown in Fig. 7C, a ground layer 17 is disposed on the upper surface of the substrate layer 11. The voltage of the ground layer 17 is in the ground level. The ground layer 17 prevents circuits on the upper and lower layers from electrically interfering and causes the thermal resistance to lower.

The substrate layer 12 is disposed above the substrate layer 11. As shown in Fig. 7B, a pattern 18 that accomplishes a bias circuit and a matching circuit is formed on the substrate layer 12.

The substrate layer 13 is disposed above the substrate layer 12. A ground region 19 is formed on the substrate layer 13. The ground region 19 is an ideal ground plane. The semiconductor chip 2 is mounted on the substrate layer 13 according to flip-chip method.

Parts other than the chip parts 3, 3, ... may be connected on the front surface of the multi-layered substrate.

As described above, according to the first embodiment of the present invention, since both the upper and lower surfaces of the substrate 1 are used to mount parts, the substrate area can be effectively used and thereby the size of the apparatus can be reduced. Heat generated by the semiconductor chip 2 flows to the cover 4. Thus, the heat is radiated from the cover 4. In addition, since the cover 4 is wisely exposed to air, the cover 4 has high heat radiation effect. Moreover, since the cover 4 is mounted on the mother board, the heat is also radiated from the mother board. Thus, the heat generated by the semiconductor chip 2 is effectively radiated. Consequently, as the substrate 1, a multi-layered substrate can be used. In addition to radiating heat, the cover 4 prevents dust from entering the integrated circuit apparatus and shields it against an electromagnetic radiation source. Thus, the cover 4 does not cause the size and cost of the apparatus to increase. In addition, as described above, since electrodes are formed along with the cover 4, the productivity of the apparatus improves.

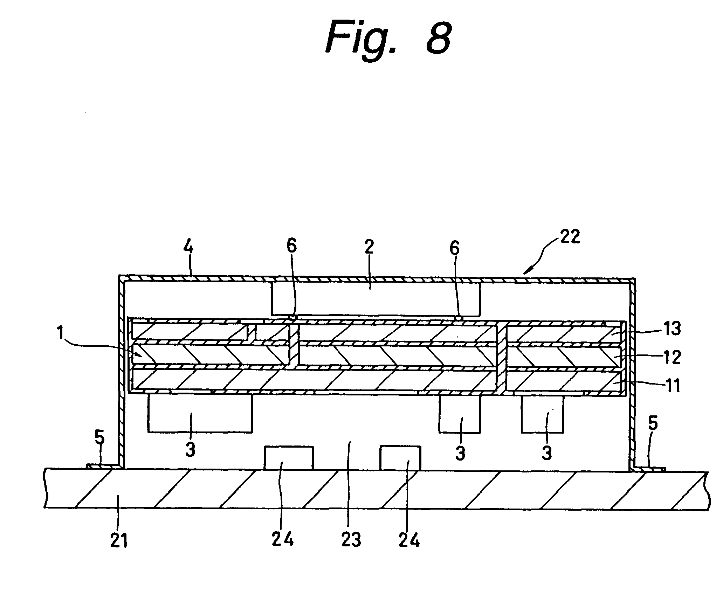

In the example, as shown in Fig. 8, the cover 4 is mounted to the mother board 21 with the connection portion 5 disposed on the outer periphery of the cover 4. Thus, a space 23 is formed between the integrated circuit apparatus 22 and the mother board 21. The space 23 allows parts 24, 24, ... to be disposed on the mother board 22 and wires to be connected.

When the cover 4 is contacted with a casing of the apparatus, the heat is more effectively radiated. The cover 4 may be curved or unevenly formed. In this case, since the surface area of the cover 4 exposed to air increases, the heat radiation effect will more improve.

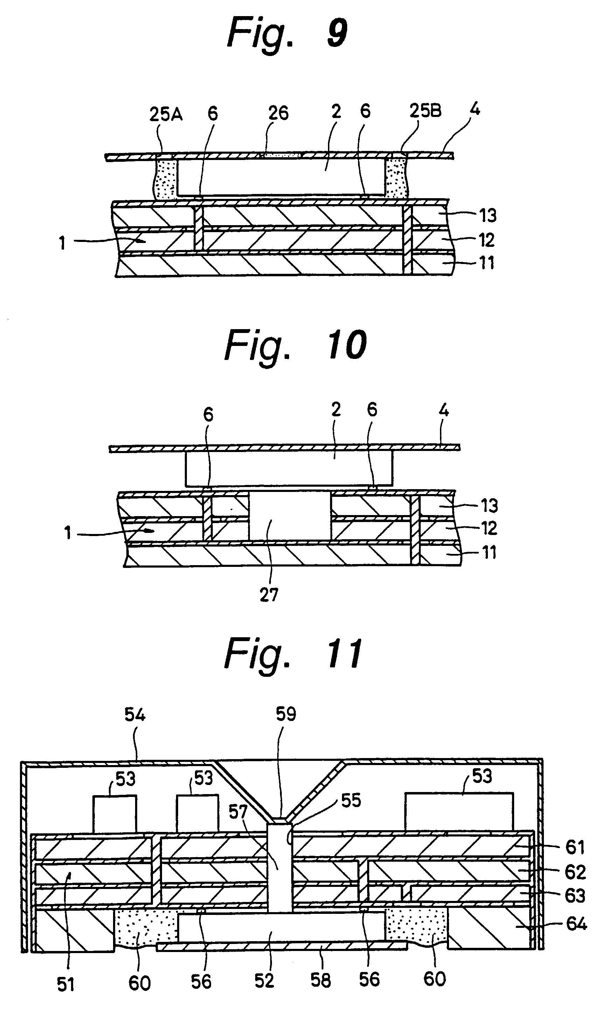

As shown in Fig. 9, when holes 25A, 25B, and 26 are formed on the front surface of the cover 4 and resin or adhesive agent is filled in the apparatus through the holes 25A, 25B, and 26, the productivity of the apparatus will improves.

Alternatively, as shown in Fig. 10, a cavity 27 may be formed with openings of the substrate layers 12 and 13 so as to prevent radio frequency characteristics from deteriorating.

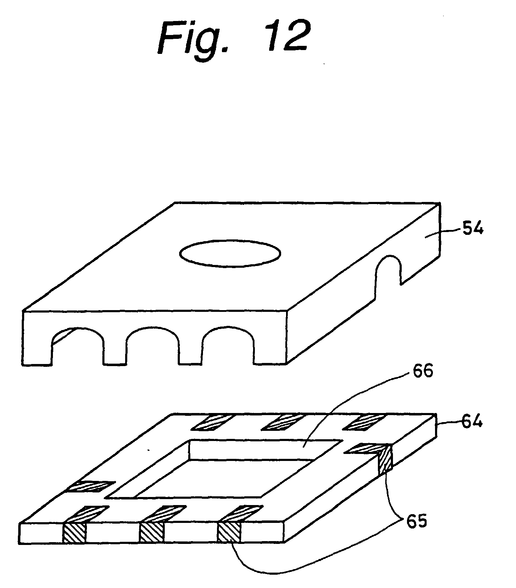

Fig. 11 is a sectional view showing the structure of an integrated circuit apparatus according to a second embodiment of the present invention. In Fig. 11, reference numeral 51 is a substrate that mounts a semiconductor chip. The substrate 51 is a multi-layered substrate having for example four substrate layers 61 to 64.

Chip parts 53, 53, ... that are resistor devices and capacitor devices are mounted on the upper surface of the substrate 51. A semiconductor chip 52 is mounted on the lower surface of the substrate 51 through bumps 56 according to flip-chip method. The chip parts 53, 53, ... compose a matching circuit and a bias circuit. The semiconductor chip 52 amplifies the power of a radio frequency signal.

As shown in Fig. 12, a substrate 64 having an opening that passes the semiconductor chip 52 is disposed. Electrodes 65 are formed on the sides and rear surface of the substrate 64. Alternatively, electrodes may be formed according to the method shown in Fig. 3 instead of the use of the substrate 64.

Thus, in the example, the chip parts 53, 53, ... that do not generate a large amount of heat are mounted on the upper surface of the substrate 51. The semiconductor chip 52 that generates a large amount of heat is disposed on the lower surface of the substrate 51. With both the upper and lower surfaces of the substrate 51, parts are mounted. Since the parts are mounted with both the upper and lower surfaces of the substrate, the substrate area can be effectively used.

A through-hole 55 is formed in the substrate 51. A heat conducting member 57 is inserted into the through-hole 55. The heat conducting member 57 is made of a metal rod with high thermal conductivity. An edge of the heat conducting member 57 contacts the semiconductor chip 52. The other edge of the heat conducting member 57 extrudes from the upper surface of the substrate 51. The heat conducting member 57 causes heat generated by the semiconductor chip 52 mounted on the lower surface of the substrate 51 to flow to the upper surface of the substrate 51. A heat radiation plate 58 is disposed on the lower surface of the semiconductor chip 52. The semiconductor chip 52 is secured with resin 60.

A cover 54 that fully encloses the substrate 51 on which the semiconductor chip 52 and the chip parts 53, 53, ... have been mounted is disposed. The material of the cover 54 is for example a metal with high thermal conductivity. A protrusion portion 59 is formed on the upper surface of the cover 54. The protrusion portion 59 of the cover 54 contacts the heat conducting member 57.

The heat radiated by the semiconductor chip 52 flows to the cover 54 through the heat conducting member 57. Since the outer periphery of the cover 54 is widely exposed to air, the heat is radiated from the cover 54 to air.

In addition, a heat radiation plate 58 is disposed on the lower surface of the semiconductor chip 52. The heat generated by the semiconductor chip 52 flows to the mother board through the heat radiation plate 58. The heat is radiated from the mother board.

In the example, one heat conducting member 57 and one protrusion portion 59 are disposed. Alternatively, a plurality of heat conducting members 57 and a plurality of protrusion portions 59 corresponding thereto may be disposed.

Thus, according to the second embodiment of the present invention, since parts are mounted on both the upper and lower surfaces of the substrate 51, the substrate area can be effectively used. Thus, the size of the apparatus can be reduced. In addition, the heat generated by the semiconductor chip 52 flows to the cover 54 through the heat conducting member 55. Since the cover 54 is widely exposed to air, the heat radiation effect is high. Moreover, the heat generated by the semiconductor chip 52 flows to the mother board through the heat radiation plate 58. Thus, the heat is also radiated from the mother board. Consequently, the heat can be effectively radiated. As a result, as the substrate 51, a multi-layered substrate can be used.

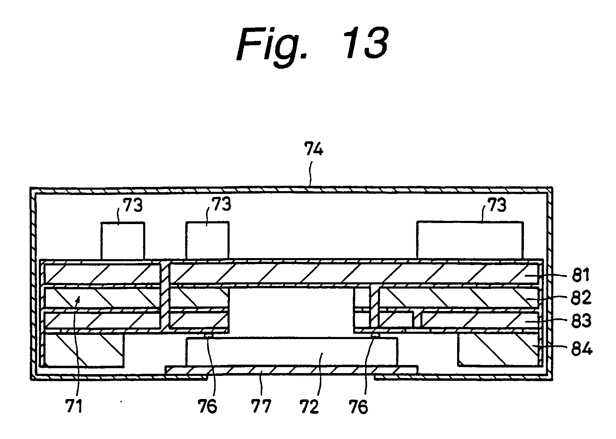

Fig. 13 is a sectional view showing the structure of an integrated circuit apparatus according to a third embodiment of the present invention. In Fig. 10, reference numeral 71 is a substrate on which a semiconductor chip is mounted. The substrate 71 is a multi-layered substrate having for example four substrate layers 81 to 84.

Chip parts 73, 73, ... such as resistor devices and capacitor devices are disposed on the upper surface of the substrate 71. A semiconductor chip 72 is mounted on the lower surface of the substrate 71 through bumps 76 according to flip-chip method. The chip parts 73, 73, ... compose a matching circuit and a bias circuit. The semiconductor chip 72 amplifies the power of a radio frequency signal.

Thus, in the example, the chip parts 73, 73, ... that generate a small amount of heat are mounted on the upper surface of the substrate 71. The semiconductor chip 72 that generates a large amount of heat is mounted on the lower surface of the substrate 71. With both the upper and lower surfaces of the substrate 71, parts are mounted. Since the parts are mounted on both the upper and lower surfaces of the substrate 71, the substrate area can be effectively used. Thus, the size of the apparatus can be reduced. A heat radiation plate 77 is disposed on the lower surface of the semiconductor chip 72.

A cover 74 that fully encloses the substrate 71 on which the semiconductor chip 72 and the chip parts 73, 73, ... have been mounted is disposed. The material of the cover 73 is for example a metal with high thermal conductivity. A bottom portion of the cover 74 internally extends and contacts the heat radiation plate 77.

The heat generated by the semiconductor chip 72 flows to a mother board through the heat radiation plate 77. In addition, the heat generated by the semiconductor chip 72 flows to the cover 74. The outer periphery of the cover 74 is widely exposed to air. Thus, the heat is radiated from the cover 74 to air.

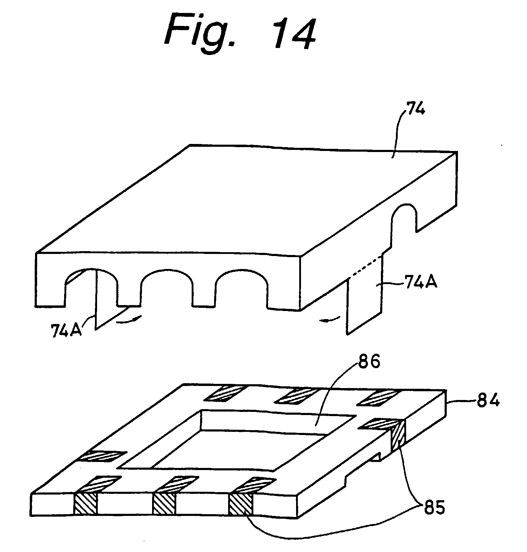

In addition, as shown in Fig. 14, a substrate 84 that has an opening that passes the semiconductor chip 72 is disposed. Electrodes 85 are formed on sides and rear surface of the substrate 84. Alternatively, electrodes may be formed according to the method shown in Fig. 6 rather than the use of the substrate 84. The cover 74 has an inner protrusion regions 74A.

Thus, according to the third embodiment of the present invention, since parts are mounted on both the upper and lower surfaces of the substrate 71, the substrate area can be effectively used. Consequently, the size of the apparatus can be reduced. The heat generated by the semiconductor chip 72 is radiated from the mother board through the heat radiation plate 77. In addition, the heat generated by the semiconductor chip 72 flows to the cover 74. Thus, the heat is radiated from the cover 74 to air. Since the cover 74 is widely exposed to air, the cover 74 has high heat radiation effect. Thus, as the substrate 71, a multi-layered substrate can be used.

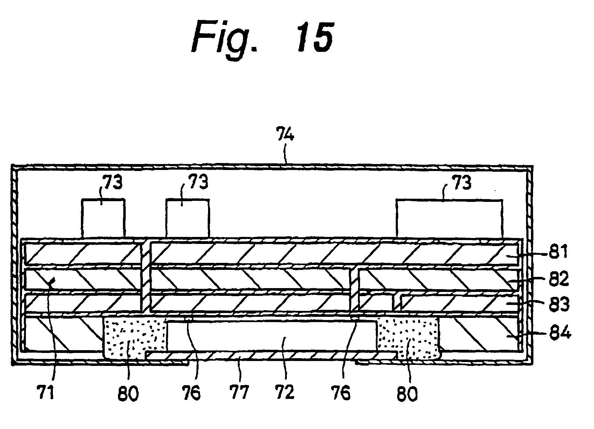

As shown in Fig. 15, the substrates 82 and 83 may have openings that form a cavity on the semiconductor chip 72 so as to prevent radio frequency characteristics from deteriorating.

According to the present invention, since a radio frequency integrated circuit apparatus according to the present invention comprises a first circuit device, generating a large amount of heat, disposed on one surface of a circuit substrate, a second circuit device, generating a small amount of heat, disposed on the other surface of the circuit substrate, and a heat radiating means for radiating the heat generated by the first circuit device, the mounting area becomes large. In addition, the problem of the heat generation can be solved.

According to the present invention, since the first circuit device, generating a large amount of heat, is mounted according to flip-chip method, the fluctuation of the wire lengths and inductance components can be suppressed.

According to the present invention, since the circuit substrate is a multi-layered substrate, parts can be densely mounted. In addition, since the multi-layered substrate contains a ground layer, it prevents electric signals from interfering and causes the thermal resistance of the apparatus to lower.

According to the present invention, since the heat radiating means functions as a cover for enclosing the circuit substrate on which the first circuit device, generating a large amount of heat, and the second circuit device, generating a small amount of heat, have been mounted, a special member for radiating heat can be omitted.

Although the present invention has been shown and described with respect to a best mode embodiment thereof, it should be understood by those skilled in the art that the foregoing and various other changes, omissions, and additions in the form and detail thereof may be made therein without departing from the spirit and scope of the present invention.

## Claims

1. A radio frequency integrated circuit apparatus, comprising:
a first circuit device, generating a large amount of heat, disposed on one surface of a circuit substrate;
a second circuit device, generating a small amount of heat, disposed on the other surface of the circuit substrate; and
heat radiating means for radiating the heat generated by said first circuit device.

2. The radio frequency integrated circuit apparatus as set forth in claim 1,
wherein said first circuit device is mounted according to flip-chip method.

3. The radio frequency integrated circuit apparatus as set forth in claim 1,
wherein the circuit substrate is a multi-layered substrate.

4. The radio frequency integrated circuit apparatus as set forth in claim 1,
wherein the multi-layered substrate has a ground layer.

5. The radio frequency integrated circuit apparatus as set forth in claim 1,
wherein said first circuit device is a semiconductor chip for amplifying the power of a radio frequency signal, and
wherein said second circuit device is a chip part that composes a matching circuit and a bias circuit.

6. The radio frequency integrated circuit apparatus as set forth in claim 1,
wherein said heat radiating means functions as a cover for enclosing the circuit substrate on which said first circuit device and said second circuit device have been mounted, said first circuit device being contacted with the cover so as to radiate the heat generated by said first circuit device.
